# EUROPÄISCHE PATENTANMELDUNG

(11) **EP 0 917 203 A2**
(43) Veröffentlichungstag der Anmeldung: **19.05.1999**
(21) Anmeldenummer: 98119220.6
(22) Anmeldetag: 12.10.1998
(51) Int. Cl.: H01L 27/108, H01L 21/8242

(54) **Gain Cell DRAM Struktur und Verfahren zu deren Herstellung**

(30) Priorität: 14.11.1997 DE 19750621
(71) Anmelder: SIEMENS AKTIENGESELLSCHAFT, 80333 München (DE)
(72) Erfinder: Krautschneider, Wolfgang, Dr., 83104 Hohenthann (DE); Schlösser, Till, 81825 München (DE)

(57) **Zusammenfassung**

Eine Speicherzelle umfaßt mindestens drei vertikale Transistoren. Ein erster Transistor und ein zweiter Transistor bzw. ein dritter Transistor sind bezüglich einer y-Achse (y), die senkrecht zu einer Oberfläche (O) eines Substrats (1) verläuft, übereinander angeordnet. Der zweite Transistor und der dritte Transistor können an gegenüberliegenden Flanken einer Halbleiterstruktur (St) angeordnet sein, während der erste Transistor an beiden Flanken angeordnet ist. Source/Drain-Gebiete der Transistoren können überlappen.

## Beschreibung

Die Erfindung betrifft eine DRAM-Zellenanordnung, d.h. eine Speicherzellen-Anordnung mit dynamischem wahlfreiem Zugriff, bei der eine Speicherzelle drei Transistoren umfaßt.

In DRAM-Zellenanordnungen werden derzeit fast ausschließlich sog. Eintransistor-Speicherzellen eingesetzt. Eine Eintransistor-Speicherzelle umfaßt einen Auslesetransistor und einen Speicherkondensator. In dem Speicherkondensator ist die Information in Form einer elektrischen Ladung gespeichert, die eine logische Größe, 0 oder 1, darstellt. Durch Ansteuerung des Auslesetransistors über eine Wortleitung kann diese Information über eine Bitleitung ausgelesen werden. Die im Speicherkondensator gespeicherte elektrische Ladung treibt dabei die Bitleitung.

Da von Speichergeneration zu Speichergeneration die Speicherdichte zunimmt, muß die benötigte Fläche der Eintransistor-Speicherzelle von Generation zu Generation reduziert werden. Dies führt zu grundlegenden technologischen und physikalischen Problemen. Beispielsweise muß der Speicherkondensator trotz kleinerer Fläche der Eintransistor-Speicherzelle eine Mindestmenge an elektrischer Ladung speichern können, um damit die Bitleitung treiben zu können.

Dieses Problem wird in einer alternativen DRAM-Zellenanordnung, in der als Speicherzellen sog. Gainzellen eingesetzt werden, umgangen. Auch hier ist die Information in Form einer elektrischen Ladung gespeichert. Die elektrische Ladung muß jedoch nicht direkt eine Bitleitung treiben, sondern wird in einer Gateelektrode eines Transistors gespeichert und dient nur zu dessen Steuerung, wozu schon eine sehr kleine Menge an elektrischer Ladung genügt.

In M. Heshami, 1996 IEEE J. of Solid-State Circuits, Vol. 31, No.3 wird eine Gainzelle, die drei Transistoren umfaßt, beschrieben. Die elektrische Ladung wird in einer ersten Gateelektrode eines ersten Transistors gespeichert. Das Speichern der elektrischen Ladung geschieht mit Hilfe eines zweiten Transistors. Die erste Gateelektrode ist mit einem ersten Source/Drain-Gebiet des zweiten Transistors und ein zweites Source/Drain-Gebiet des zweiten Transistors mit einer schreibenden Bitleitung verbunden. Zum Speichern wird eine zweite Gateelektrode des zweiten Transistors über eine schreibende Wortleitung angesteuert. Die Menge an elektrischer Ladung und damit die Information, die dabei in der ersten Gateelektrode gespeichert wird, wird durch eine Spannung an der schreibenden Bitleitung bestimmt. Das Auslesen der Information geschieht mit Hilfe eines dritten Transistors. Ein zweites Source/Drain-Gebiet des ersten Transistors ist mit einem ersten Source/Drain-Gebiet des dritten Transistors und ein zweites Source/Drain-Gebiet des dritten Transistors mit einer auslesenden Bitleitung verbunden. Zum Auslesen wird eine dritte Gateelektrode des dritten Transistors über eine auslesende Wortleitung angesteuert. Die Menge an elektrischer Ladung, und damit die Information, wird über die auslesende Bitleitung ausgelesen.

Der Erfindung liegt das Problem zugrunde, eine DRAM-Zellenanordnung anzugeben, die als Speicherzellen Gainzellen mit jeweils mindestens drei Transistoren umfaßt und mit im Vergleich zum Stand der Technik erhöhter Packungsdichte herstellbar ist. Ferner soll ein Herstellungsverfahren für eine solche DRAM-Zellenanordnung angegeben werden.

Dieses Problem wird gelost durch eine DRAM-Zellenanordnung gemaß Anspruch 1 sowie ein Verfahren zu deren Herstellung gemäß Anspruch 9. Weitere Ausgestaltungen der Erfindung gehen aus den übrigen Ansprüchen hervor.

In einer erfindungsgemäßen DRAM-Zellenanordnung ist ein Substrat mit Speicherzellen vorgesehen, die jeweils mindestens einen ersten Transistor, einen zweiten Transistor und einen dritten Transistor umfassen. Die drei Transistoren sind bezüglich einer y-Achse, die senkrecht zu einer Oberfläche des Substrats verläuft, vertikal ausgebildet. Der erste Transistor und der zweite Transistor beziehungsweise der dritte Transistor sind bezuglich der y-Achse übereinander angeordnet. Durch diese Anordnung wird die benötigte Flache pro Speicherzelle reduziert.

Zur Verkurzung der Verbindungswege zwischen den drei Transistoren ist es vorteilhaft, wenn zwei der Transistoren im wesentlichen lateral zueinander angeordnet sind.

Es liegt im Rahmen der Erfindung, die drei Transistoren an Flanken einer Halbleiterstruktur anzuordnen. Source/Drain-Gebiete der Transistoren sind als von einem ersten Leitfähigkeitstyp dotierte Gebiete innerhalb der Halbleiterstruktur oder lateral an die Halbleiterstruktur angrenzend realisiert. Der zweite Transistor kann im wesentlichen an einer ersten Flanke der Halbleiterstruktur und der dritte Transistor im wesentlichen an einer zweiten Flanke der Halbleiterstruktur angeordnet sein. Die Flanken, an denen Transistoren angeordnet sind, sind mit einem Gatedielektrikum versehen. Es liegt im Rahmen der Erfindung, daß der erste Transistor unterhalb dem zweiten Transistor und dem dritten Transistor angeordnet ist.

Die Halbleiterstruktur kann z.B. einen runden Querschnitt aufweisen. In diesem Fall gehen die Flanken ineinander über. Der Querschnitt der Halbleiterstruktur kann auch rechteckig oder mehreckig sein. Entlang einer Wortleitung benachbarte Halbleiterstrukturen können voneinander getrennt sein oder zusammenhängen und streifenförmige Strukturen bilden.

Die Halbleiterstruktur kann z. B. durch maskiertes Ätzen des Substrats erzeugt werden. Alternativ kann die Halbleiterstruktur epitaktisch aufgewachsen werden. Die Halbleiterstruktur kann auch durch Abscheiden von Material in einer in einer Schicht erzeugten Vertiefung erzeugt werden.

Die Halbleiterstruktur kann eine Schichtenfolge umfassen, mit Schichten entsprechend Kanalgebieten und der Source/Drain-Gebiete. Die Schichtenfolge kann z.B. durch Epitaxie mit insitu-Dotierung erzeugt werden. Alternativ kann eine obere Schicht durch Implantation erzeugt werden. Zur Vermeidung von Kapazitäten und Punch-Through zwischen übereinander angeordneten Source/Drain-Gebieten ist es vorteilhaft, mindestens ein Source/Drain-Gebiet lateral an die Halbleiterstruktur angrenzend auszubilden. Dieses laterale Source/Drain-Gebiet kann beispielsweise durch Implantation erzeugt werden. Alternativ wird eine als Dotierstoffquelle dienende Schicht aus z.B. Phosphorsilikatglas oder Arsensilikatglas abgeschieden, aus der Dotierstoff in die die Halbleiterstruktur umgebenden Gebiete diffundiert wird.

Da die Information auf einer ersten Gateelektrode des ersten Transistors gespeichert wird, ist es vorteilhaft, wenn die Kapazität an der ersten Gateelektrode besonders groß ist. Dazu kann die erste Gateelektrode an mehrere Flanken der Halbleiterstruktur angrenzen. Vorzugsweise umgibt die erste Gateelektrode die Halbleiterstruktur.

Zur Verkurzung der Verbindungswege ist es vorteilhaft, wenn die erste Gateelektrode mindestens an die erste Flanke und an die zweite Flanke der Halbleiterstruktur angrenzt.

Zur Prozeßvereinfachung ist es vorteilhaft, wenn die erste Flanke der zweiten Flanke gegenüberliegt. In diesem Fall kann eine schreibende Wortleitung entlang der ersten Flanke und eine auslesende Wortleitung entlang der zweiten Flanke verlaufen.

Um eine Verbindung zwischen der ersten Gateelektrode und einem ersten Source/Drain-Gebiet des zweiten Transistors zu ermöglichen, weist das Gatedielektrikum im Bereich der ersten Gateelektrode an der ersten Flanke eine Unterbrechung auf. An der Unterbrechung grenzt dadurch die erste Gateelekrode direkt an die Halbleiterstruktur oder an ein in der Halbleiterstruktur angeordnetes Verbindungselement an. Ist ein Verbindungselement vorhanden, so grenzt das Verbindungselement auch an das erste Source/Drain-Gebiet des zweiten Transistors an.

Um das Gatedielektrikum mit der Unterbrechung zu erzeugen, kann z. B. für den Fall, daß der erste Transistor unterhalb des zweiten Transistors und des dritten Transistors angeordnet ist, nach Erzeugung der Halbleiterstruktur z. B. durch thermische Oxidation an den Flanken der Halbleiterstruktur ein erster Teil des Gatedielektrikums erzeugt werden. Wenn ein laterales Source/Drain-Gebiet erzeugt wurde, ist das Gatedielektrikum Gd dort dicker als an Flanken der Halbleiterstruktur, da die Dicke des durch thermische Oxidation erzeugten Gatedielektrikums um so größer ist je höher die Dotierstoffkonzentration des angrenzenden Gebiets ist. Durch Abscheiden und Rückätzen von Material bis zu einer ersten Höhe, wird die erste Gateelektrode erzeugt. Anschließend wird das isolierende Material geätzt, bis Teile des Gatedielektrikums an den Flanken oberhalb der ersten Höhe entfernt werden. Die erste Gateelektrode dient dabei als Maske. Da der Teil des Gatedielektrikums auf dem lateralen Source/Drain-Gebiet besonders dick ist, wird er dort nicht vollständig entfernt. Durch Abscheiden und Rückätzen von Material bis zu einer zweiten Höhe, die oberhalb der ersten Höhe liegt, wird die erste Gateelektrode vergrößert. Da auf dem lateralen Source/Drain-Gebiet ein Teil des Gatedielektrikums angeordnet ist, entsteht kein Kurzschluß zur ersten Gateelektrode. Die erste Gateelektrode grenzt damit in einem Bereich zwischen der ersten Höhe und der zweiten Höhe direkt an die Halbleiterstruktur an. Mit Hilfe einer Maske, die mindestens die zweite Flanke nicht bedeckt, wird anschließend das Material weiter geätzt, bis die erste Gateelektrode an der zweiten Flanke bis zu einer dritten Höhe reicht, die unterhalb der ersten Höhe liegt. Die erste Gateelektrode grenzt damit im Bereich der zweiten Flanke nicht direkt an die Halbleiterstruktur an. Z. B. durch thermische Oxidation oder durch Abscheiden von Material an der ersten Flanke und an der zweiten Flanke wird ein zweiter Teil des Gatedielektrikums erzeugt. Das Gatedielektrikum weist damit mindestens an der ersten Flanke zwischen der ersten Höhe und der zweiten Höhe eine Unterbrechung auf.

Zur Verkleinerung der Kapazität zwischen dem lateralen Source/Drain-Gebiet und der ersten Gateelektrode oder/und zur Prozeßsicherheit ist es vorteilhaft, wenn z.B. vor der Entfernung des Gatedielektrikums von den oberen Teilen der Flanken der Halbleiterstruktur eine Hilfsschicht erzeugt wird, die bis unterhalb der ersten Höhe reicht. Die Hilfsschicht schützt die Halbleiterstruktur umgebende Teile des Gatedielektrikums bei der Entfernung des Gatedielektrikums an den oberen Teilen der Flanken. In diesem Fall kann das Gatedielektrikum auch durch Abscheiden von isolierendem Material erzeugt werden.

Alternativ wird die Hilfsschicht erzeugt, bevor die erste Gateelektrode erzeugt wird. Dazu ist z.B. die als Dotierstoffquelle dienende Schicht geeignet. In diesem Fall ist die Hilfsschicht vorzugsweise dünn, damit die erste Gateelektrode möglichst nah an das unteren Ende der Halbleiterstruktur angrenzt.

Statt die erste Gateelektrode als Maske bei der teilweisen Entfernung des Gatedielektrikums zu verwenden, können die Flanken bis zur ersten Höhe mit einem Hilfsspacer bedeckt werden. In diesem Fall kann vor Erzeugung der ersten Gateelektrode zwischen Halbleiterstrukturen eine isolierende Schicht gebildet werden, damit die erste Gateelektrode außerhalb der Halbleiterstruktur nicht direkt an das Substrat angrenzt.

Zur Erhöhung der Packungsdichte ist es vorteilhaft, wenn das erste Source/Drain-Gebiet des zweiten Transistors als Teil der Halbleiterstruktur im Bereich der Unterbrechung angeordnet ist. In diesem Fall ist es vorteilhaft an der ersten Flanke ein Element anzuordnen, das die Ausbildung eines Kanalstroms zwischen einem ersten Source/Drain-Gebiet des ersten Transistors und einem ersten Source/Drain-Gebiet des zweiten Transistors unterdruckt. Das Element, das die Ausbildung eines Kanalstroms verhindert, kann beispielsweise als Channel-Stop-Gebiet innerhalb der Halbleiterstruktur angrenzend an die erste Flanke ausgebildet sein. Das Channel-Stop-Gebiet weist eine hohe Dotierstoffkonzentration auf und ist vom zweiten, zum ersten Leitfähigkeitstyp entgegengesetzten Leitfähigkeitstyp dotiert.
Das Element, das den Kanalstrom unterdruckt, kann auch als isolierende Struktur aus einem isolierenden Material, wie z.B. SiO₂, zwischen der ersten Gateelektrode und der Halbleiterstruktur vorzugsweise knapp unterhalb der Unterbrechung ausgebildet sein.

Das Channel-Stop-Gebiet kann Z. B. durch schräge Implantation oder durch Ausdiffusion aus einer Dotierstoffquelle erzeugt werden. Für die schräge Implantation wird z.B. ein Schutzspacer an mindestens der ersten Flanke zwischen einer ersten Höhe und der Oberfläche des Substrats angebracht. Dies geschieht z.B. indem zunächst eine Schicht, die bis zur ersten Höhe reicht, erzeugt wird und der Schutzspacer anschließend durch Abscheiden und Rückätzen von Material erzeugt wird. Die Schicht wird vor der schrägen Implantation entfernt. Aufgrund des Schutzspacers entsteht nur unterhalb der ersten Höhe ein Channel-Stop-Gebiet. Für die Ausdiffusion kann z.B. nach Erzeugung der Halbleiterstruktur eine Dotierstoffquelle erzeugt werden, die die erste Flanke bis zur ersten Höhe bedeckt, indem z.B. dotiertes Silizium oder Borsilikatglas abgeschieden und rückgeätzt wird. Nach Ausdiffusion des Dotierstoffs kann die Dotierstoffquelle wieder entfernt werden.

Zur Erhöhung der Packungsdichte ist es vorteilhaft, wenn ein erstes Source/Drain-Gebiet des dritten Transistors mit einem zweiten Source/Drain-Gebiet des ersten Transistors zusammenfällt. Das zweite Source/Drain-Gebiet des ersten Transistors und das erste Source/Drain-Gebiet des dritten Transistors können beispielsweise als ein erstes dotiertes Gebiet ausgebildet sein. Das erste dotierte Gebiet kann z.B. durch schräge Implantation oder durch Ausdiffusion aus einer Dotierstoffquelle, z.B. einer dotierten Schicht, erzeugt werden. Es ist vorteilhaft, wenn das Gatedielektrikum an der zweiten Flanke eine weitere Unterbrechung aufweist, durch die der Dotierstoff diffundieren kann. Dazu wird die dotierte Schicht beispielsweise vor Fertigstellung des Gatedielektrikums oberhalb und angrenzend an die erste Höhe aufgebracht. Nach der Ausdiffusion muß die dotierte Schicht nicht entfernt werden.

Die Halbleiterstruktur kann durch maskiertes Ätzen in einem Schritt erzeugt werden. Zur Isolation der Speicherzellen voneinander, kann nach Erzeugung der ersten Gateelektrode isolierendes Material abgeschieden werden und mit Hilfe einer streifenförmigen Maske, deren Streifen parallel zu den zu erzeugenden Wortleitungen verlaufen und die Halbleiterstrukturen bedecken, geätzt werden. Dadurch entsteht eine erste isolierende Struktur, die zwischen entlang der schreibenden Wortleitung benachbarten Halbleiterstrukturen bis zur Oberflache reicht. Um zu gewährleisten, daß das isolierende Material trotz endlicher Justiertoleranzen von der ersten Flanke und der zweiten Flanke der Halbleiterstruktur entfernt wird, ist es vorteilhaft, wenn die streifenförmige Maske enger als die Halbleiterstruktur ist und damit die Halbleiterstruktur nicht vollständig bedeckt. Alternativ kann eine Maske verwendet werden, die im wesentlichen Bereiche zwischen entlang der Wortleitung benachbarten Halbleiterstrukturen bedeckt. Es ist vorteilhaft, bei der Erzeugung der ersten isolierenden Struktur das isolierende Material außerhalb der Maske nicht vollständig zu entfernen, sondern z.B. bis etwa zur dritten Höhe zu ätzen. Dadurch reicht die erste isolierende Struktur zwischen quer zu den Wortleitungen benachbarten Halbleiterstrukturen z.B. bis etwa zur dritten Höhe. Auf diesem Teil der ersten isolierenden Struktur kann die dotierte Schicht, aus der Dotierstoff für das erste dotierte Gebiet ausdiffundiert wird, angeordnet werden. Diese Teile der ersten isolierenden Schicht verringern Kapazitäten, die durch benachbarte Gateelektroden gebildet werden.

Alternativ kann die Halbleiterstruktur erzeugt werden, indem zunächst mit Hilfe einer streifenförmigen Maske Graben, die senkrecht zu den zu erzeugenden Wortleitungen verlaufen, in das Substrat geätzt werden, wodurch streifenförmige, vorläufige Halbleiterstrukturen entstehen. Nach Erzeugung von Teilen des Gatedielektrikums und der ersten Gateelektrode an einer dritten und vierten Flanke jeder vorläufigen Halbleiterstruktur, wird isolierendes Material abgeschieden. Mit Hilfe einer streifenförmigen Maske, deren Streifen parallel zu den zu erzeugenden Wortleitungen verlaufen, wird Halbleitermaterial und isolierendes Material geätzt, wodurch aus den vorläufigen Halbleiterstrukturen die Halbleiterstrukturen und zwischen entlang der Wortleitung benachbarten Halbleiterstrukturen befindliche erste isolierende Strukturen entstehen.

Durch Abscheiden und Rückätzen von Material kann an der ersten Flanke eine zweite Gateelektrode als Teil der schreibenden Wortleitung und an der zweiten Flanke die dritte Gateelektrode als Teil einer auslesenden Wortleitung erzeugt werden.

Zur Erhöhung der Packungsdichte ist es vorteilhaft, wenn eine schreibende Bitleitung und eine auslesende Bitleitung identisch sind und eine Bitleitung bilden. Die Bitleitung ist mit einem zweiten Source/Drain-Gebiet des zweiten Transistors und mit einem zweiten Source/Drain-Gebiet des dritten Transistors verbunden.

Zur Erhöhung der Packungsdichte ist es vorteilhaft, wenn das zweite Source/Drain-Gebiet des zweiten Transistors mit dem zweiten Source/Drain-Gebiet des dritten Transistors zusammenfallt. Zur Erzeugung kann das Substrat vor Erzeugung der Halbleiterstruktur implantiert werden.

Zur Erhöhung der Packungsdichte ist es vorteilhaft, wenn entlang der Bitleitung benachbarte Halbleiterstrukturen spiegelbildlich zueinander angeordnet sind.

Source/Drain-Gebiete können n- oder p-dotiert sein.

Die Gateelektroden können dotiertes Polysilizium, Metalle und/oder Metallsilizide enthalten. Dotiertes Polysilizium kann beim Abscheiden in situ dotiert sein oder nachträglich dotiert werden.

Im folgenden wird die Erfindung anhand der Ausführungsbeispiele, die in den Figuren dargestellt sind, naher erläutert.
- Figur 1: zeigt einen Ausschnitt aus einer Aufsicht auf ein erstes Substrat, nachdem eine erste Maske, eine Halbleiterstruktur, ein zweites Source/Drain-Gebiet eines zweiten Transistors und ein zweites Source/Drain-Gebiet eines dritten Transistors erzeugt wurden.
- Figur 2: zeigt einen zu Figur 1 senkrechten Querschnitt durch das erste Substrat, nach den Prozeßschritten aus Figur 1 und nachdem ein erstes Source/Drain-Gebiet eines ersten Transistors, ein Teil eines Gatedielektrikums, ein Channel-Stop-Gebiet, eine erste Gateelektrode des ersten Transistors und eine Hilfsschicht erzeugt wurden.
- Figur 3: zeigt den Querschnitt aus Figur 2, nachdem ein erster Teil der ersten Gateelektrode und ein zweiter Teil der ersten Gateelektrode erzeugt wurden.
- Figur 4: zeigt die Aufsicht auf Figur 1, nach den Prozeßschritten aus Figur 3 und nachdem eine erste isolierende Struktur, eine dotierte Schicht, ein weiterer Teil des Gatedielektrikums, eine zweite isolierende Struktur, eine zweite Gateelektrode, eine schreibende Wortleitung, eine dritte Gateelektrode und eine auslesende Wortleitung erzeugt wurden.
- Figur 5: zeigt den Querschnitt aus Figur 3 nach den Prozeßschritten aus Figur 4 und nachdem eine dritte isolierende Struktur und Bitleitungen erzeugt wurden.
- Figur 6: zeigt einen Ausschnitt aus einer Aufsicht auf ein zweites Substrat, nachdem eine erste Maske, eine vorläufige Halbleiterstruktur, ein Teil eines Gatedielektrikums und ein Teil einer ersten Gateelektrode erzeugt wurden.
- Figur 7: zeigt die Aufsicht aus Figur 6, nachdem eine erste isolierende Struktur erzeugt und ein weiterer Teil der ersten Gateelektrode fertiggestellt wurden.
- Figur 8: zeigt die Aufsicht aus Figur 7, nachdem benachbarte erste Gateelektroden voneinander getrennt wurden.

Die Figuren sind nicht maßstäblich.

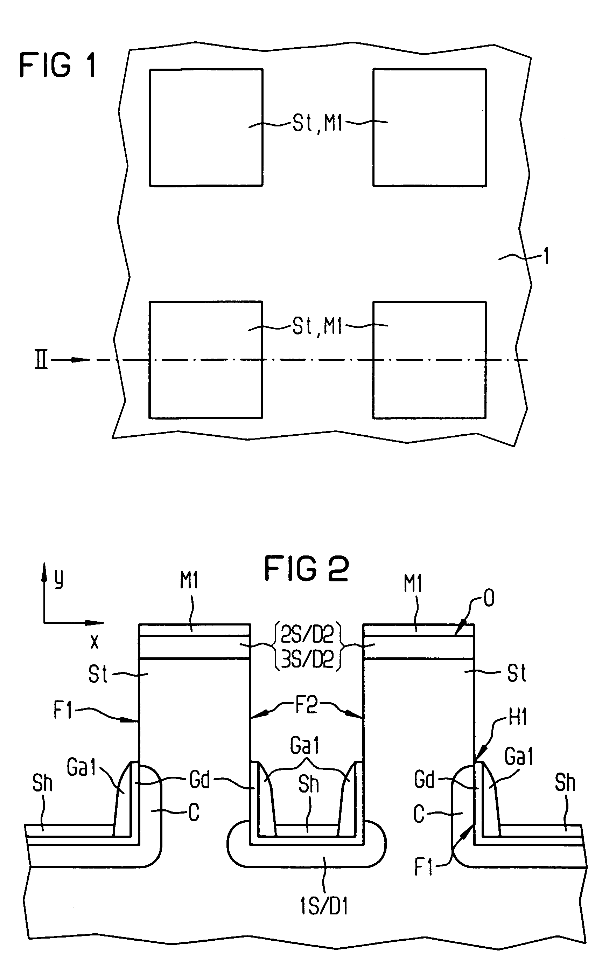

In einem ersten Ausführungsbeispiel wird ein erstes Substrat 1, das Silizium enthalt, an einer Oberflache O implantiert. Dadurch entsteht eine ca. 200 nm dicke n-dotierte Schicht (nicht dargestellt). Die Dotierstoffkonzentration der Schicht beträgt ca. 10²⁰ cm⁻³. Zur Erzeugung einer ersten Maske M1, wird Siliziumnitrid in einer Dicke von ca. 200 nm abgeschieden und durch ein photolithographisches Verfahren strukturiert. Die erste Maske M1 bedeckt z. B. quadratische Gebiete mit einer Seitenlänge von ca. 180 nm. Die quadratischen Gebiete sind regelmäßig angeordnet und ein Abstand zwischen Mittelpunkten benachbarter quadratischer Gebiete betragt ca. 360 nm (s. Figur 1). Durch Ätzen von Silizium mit Hilfe der ersten Maske M1 wird unterhalb der quadratischen Gebiete jeweils eine ca. 1500 nm hohe Halbleiterstruktur St erzeugt (s. Figur 1). Aus der n-dotierten Schicht entstehen dabei ein zweites Source/Drain-Gebiet 2S/D2 eines zweiten Transistors, das auch als ein zweites Source/Drain-Gebiet 3S/D2 eines dritten Transistors geeignet ist.

Je zwei entlang einer x-Achse x, die parallel zur Oberflache O verläuft, benachbarte Halbleiterstrukturen St, deren zweite Flanken F2 einander gegenüberliegen, bilden ein Paar. Durch eine ganzflächige Implantation wird die Halbleiterstruktur St von einem dotierten Gebiet umgeben. Ein Teil des dotierten Gebiets, der sich zwischen den zweiten Flanken F2 befindet, ist als erstes Source/Drain-Gebiet 1S/D1 eines ersten Transistors geeignet (s. Fig. 2). Das erste Source/Drain-Gebiet 1S/D1 des ersten Transistors ist ca. 300 nm tief und n-dotiert. Die Dotierstoffkonzentration des ersten Source/Drain-Gebiets 1S/D1 des ersten Transistors betragt ca. 10²⁰ cm⁻³. Durch einen Temperschritt diffundiert Dotierstoff des ersten Source/Drain-Gebiets 1S/D1 des ersten Transistors etwas in die Halbleiterstruktur St hinein (s. Figur 2).

Anschließend wird zur Erzeugung eines Channel-Stop-Gebiets C Borsilikatglas in einer Dicke von ca. 1200nm abgeschieden und bis zu einer ersten Höhe H1 zurückgeätzt. Die erste Höhe H1 liegt ca. 750 nm unterhalb der Oberfläche O. Mit Hilfe einer Maske (nicht dargestellt), die das erste Source/Drain-Gebiet 1S/D1 des ersten Transistors nicht bedeckt, wird Borsilikatglas geätzt, bis das erste Source/Drain-Gebiet 1S/D1 des ersten Transistors freigelegt wird. Als Ätzmittel ist z. B. Flußsäure geeignet. Durch einen Temperschritt diffundiert Dotierstoff aus dem Borsilikatglas in eine erste, der zweiten Flanke F2 gegenüberliegenden Flanke F1 der Halbleiterstruktur St und bildet dort das p-dotierte Channel-Stop-Gebiet C. Die Dotierstoffkonzentration des Channel-Stop-Gebiets C beträgt ca. 10¹⁹ cm⁻³. Anschließend wird das Borsilikatglas entfernt.

Zur Erzeugung eines Gatedielektrikums Gd werden durch thermische Oxidation die Flanken der Halbleiterstruktur St und das dotierte Gebiet, das die Halbleiterstruktur St umgibt, mit SiO₂ versehen (s. Figur 2).

Zur Erzeugung einer ersten Gateelektrode Ga1 des ersten Transistors wird in situ dotiertes Polysilizium in einer Dicke von ca. 30 nm abgeschieden und bis zur ersten Höhe H1 zurückgeätzt. Anschließend wird eine Hilfsschicht Sh erzeugt, indem Siliziumnitrid in einer Dicke von ca. 150 um abgeschieden, planarisiert und bis unterhalb der ersten Höhe H1 rückgeätzt wird. Als Ätzmittel ist z. B. CHF₃ geeignet (s. Figur 2). Die erste Gateelektrode Ga1 und die Hilfsschicht Sh dienen als Maske bei der Entfernung von SiO₂ von oberen Teilen der Flanken der Halbleiterstruktur St (s. Figur 2). Als Ätzmittel ist z. B. HF geeignet. An den Flanken übrigbleibendes SiO₂ bildet einen Teil des Gatedielektrikums Gd.

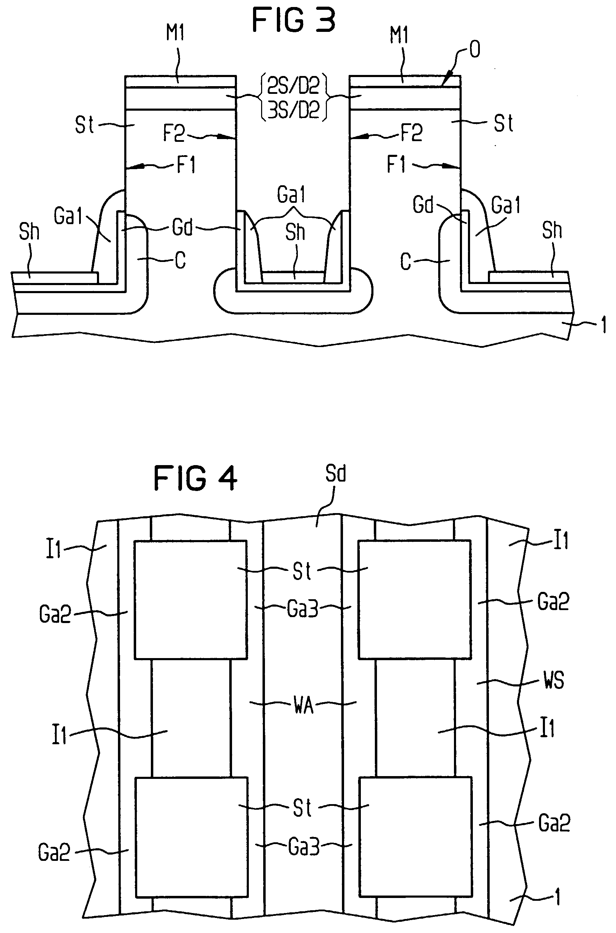

Zur Vergrößerung der ersten Gateelektrode Ga1 wird in situ dotiertes Polysilizium in einer Dicke von ca. 30 nm abgeschieden und bis zu einer zweiten Höhe H2 rückgeätzt. Die zweite Höhe H2 liegt oberhalb der ersten Höhe H1 und ca. 650 nm unterhalb der Oberfläche O (s. Figur 3).

Mit Hilfe einer Maske (nicht dargestellt), die die erste Flanke F1 bedeckt, wird das Polysilizium bis zu einer dritten Höhe H3 rückgeätzt. Die dritte Höhe H3 liegt unterhalb der ersten Höhe H1 und ca. 850 nm unterhalb der Oberflache O. Dadurch ist die erste Gateelektrode Ga1 an der zweiten Flanke F2 kleiner als an der ersten Flanke F1. An der ersten Flanke F1 grenzt die erste Gateelektrode Ga1 zwischen der ersten Höhe H1 und der zweiten Höhe H2 direkt an die Halbleiterstruktur St an.

Anschließend wird SiO₂ in einer Dicke von ca. 600 nm abgeschieden, durch chemisch-mechanisches Polieren planarisiert und mit Hilfe einer streifenförmigen Maske (nicht dargestellt), deren Streifen senkrecht zur x-Achse x verlaufen, schmaler als die Halbleiterstruktur St sind und, Halbleiterstruktur St teilweise bedecken und die erste Flanke F1 und die zweite Flanke F2 nicht bedecken, bis knapp unterhalb der dritten Höhe H3 geätzt. Als Ätzmittel ist z. B. CHF₃ geeignet. Dadurch entsteht eine erste isolierende Struktur I1, die zwischen senkrecht zu der x-Achse x benachbarte Halbleiterstrukturen St bis zur Oberfläche O reicht und zwischen entlang der x-Achse x benachbarten Halbleiterstrukturen St bis knapp unterhalb der dritten Höhe H3 reicht (s. Figur 4).

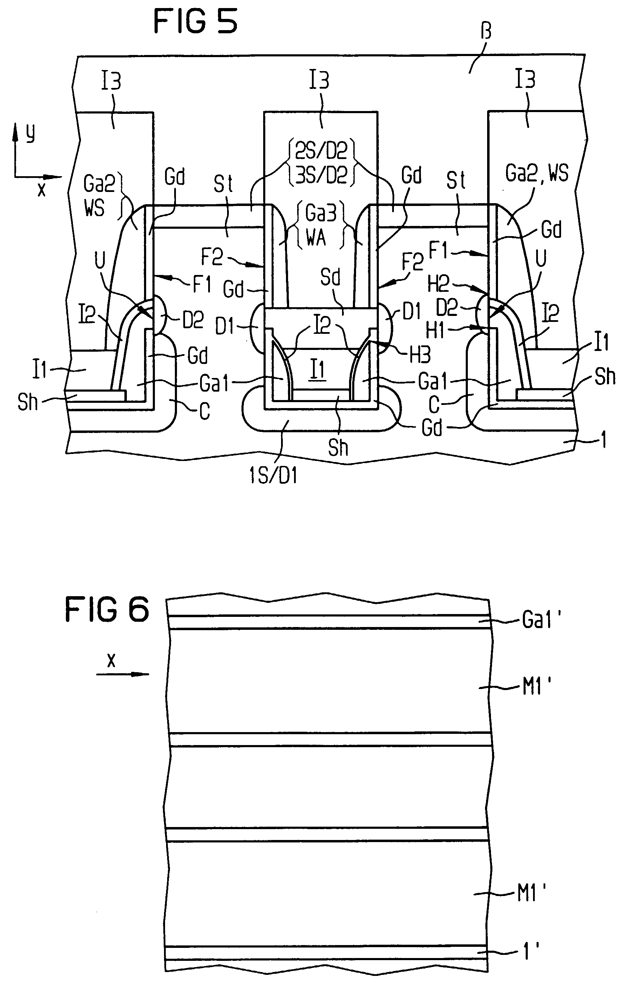

Anschließend wird Phosphorsilikatglas in einer Dicke von ca. 600 nm abgeschieden, durch chemisch-mechanisches Polieren planarisiert und bis knapp oberhalb der ersten Höhe H1 zurückgeätzt. Mit Hilfe einer Maske (nicht dargestellt), die Bereiche zwischen den zweiten Flanken F2 der Halbleiterstrukturen St bedeckt, wird Phosphorsilikatglas geätzt, bis die erste isolierende Struktur I1 teilweise freigelegt wird. Dadurch entsteht zwischen den zweiten Flanken F2 der Halbleiterstrukturen St eine isolierende dotierte Schicht Sd aus Phosphorsilikatglas (s. Figur 5). Die isolierende dotierte Schicht Sd grenzt oberhalb der ersten Höhe H1 direkt an die Halbleiterstruktur St an.

Durch eine thermische Oxidation wird anschließend das Gatedielektrikum Gd vervollständigt. Die erste Flanke F1 der Halbleiterstruktur St bedeckt das Gatedielektrikum Gd bis auf eine Unterbrechung U zwischen der ersten Höhe H1 und der zweiten Höhe H2. Durch die thermische Oxidation entsteht auf der ersten Gateelektrode Ga1 eine zweite isolierende Struktur I2 (s. Figur 5).

Anschließend wird in situ dotiertes Polysilizium in einer Dicke von ca 50 nm abgeschieden und rückgeätzt, wodurch entlang der ersten Flanke F1 eine schreibende Wortleitung WS und als Teil der schreibenden Wortleitung WS eine zweite Gateelektrode Ga2 eines zweiten Transistors, die an die erste Flanke F1 angrenzt, entstehen und entlang der zweiten Flanke F2 eine auslesende Wortleitung WA und als Teil der auslesenden Wortleitung WA eine dritte Gateelektrode Ga3 eines dritten Transistors, die an die zweite Flanke F2 angrenzt, entstehen.

Durch Abscheiden von SiO₂ in einer Dicke von ca. 600 nm und chemisch-mechanisches Polieren entsteht eine dritte isolierende Struktur I3, die als Zwischenoxid dient. Durch maskiertes Ätzen von SiO₂ wird die Halbleiterstruktur St teilweise freigelegt.
Zur Erzeugung einer Bitleitung B wird Wolfram abgeschieden und strukturiert. Die Bitleitung B verbindet zweite Source/Drain-Gebiet 2S/D2 von zweiten Transistoren von entlang der x-Achse x benachbarten Halbleiterstrukturen St (s. Figur 5).

Durch einen Temperschritt diffundiert Dotierstoff aus der isolierenden dotierten Schicht Sd oberhalb der ersten Höhe H1 in die zweite Flanke F2 der Halbleiterstruktur St und bildet ein erstes dotiertes Gebiet D1. Das erste dotierte Gebiet D1 ist zugleich als zweites Source/Drain-Gebiet des ersten Transistors und als erstes Source/Drain-Gebiet des dritten Transistors geeignet. Durch den Temperschritt wird auch Dotierstoff aus der ersten Gateelektrode Ga1 im Bereich der Unterbrechung U des Gatedielektrikums Gd an der ersten Flanke F1 in die Halbleiterstruktur St ausdiffundiert. Dadurch entsteht ein zweites dotiertes Gebiet D2, das als erstes Source/Drain-Gebiet des zweiten Transistors geeignet ist. Das Channel-Stop-Gebiet C verhindert einen Kanalstrom zwischen dem ersten Source/Drain-Gebiet 1S/D1 des ersten Transistors und dem ersten Source/Drain-Gebiet des zweiten Transistors.

In einem zweiten Ausführungsbeispiel wird an einer Oberflache eines zweiten Substrats 1' eine streifenförmige erste Maske M1' aus Siliziumnitrid erzeugt, deren Streifen entlang einer x-Achse x', die parallel zur Oberflache O' verlauft, verlaufen (s. Figur 6). Anschließend wird Silizium selektiv zu Siliziumnitrid geätzt, wodurch unterhalb der ersten Maske M1' ca. 1200 nm hohe vorläufige Halbleiterstrukturen entstehen.

Zur Erzeugung eines ersten Teils eines Gatedielektrikums wird eine thermische Oxidation durchgeführt. Anschließend erfolgt eine Implantation mit n-dotierenden Ionen. Zur Erzeugung eines ersten Teils einer ersten Gateelektrode Ga1' eines ersten Transistors wird in situ dotiertes Polysilizium in einer Dicke von ca. 50 nm abgeschieden und bis zu einer ersten Höhe rückgeätzt, die sich ca. 750 nm unterhalb der Oberflache befindet (s. Figur 6). Anschließend wird SiO₂ in einer Dicke von ca. 600 nm abgeschieden, durch chemisch-mechanisches Polieren planarisiert und geätzt bis die erste Maske M1' freigelegt wird. Mit Hilfe einer streifenförmigen Maske (nicht dargestellt), deren Streifen senkrecht zu den Streifen der ersten Maske M1' verlaufen, wird Silizium, Siliziumnitrid und SiO₂ ca. 1200nm tief geätzt. Als Ätzmittel sind z.B. Cl₂ und CHF₃ geeignet. Dabei wird die erste Maske M1' so verändert, daß sie zum ersten Ausführungsbeispiel analoge quadratische Gebiete mit einer Seitenlange von ca. 180 nm bedeckt. Abstände zwischen Mittelpunkten benachbarter quadratischer Gebiete betragen jeweils ca. 360 nm. Aus den vorläufigen Halbleiterstrukturen entstehen unter den quadratischen Gebieten jeweils eine Halbleiterstruktur St' und zwischen senkrecht zur x-Achse x' benachbarten Halbleiterstrukturen St' jeweils eine erste isolierende Struktur I1'.

Analog wie im ersten Ausführungsbeispiel werden ein erstes Source/Drain-Gebiet eines ersten Transistors und ein Channel-Stop-Gebiet erzeugt.

Zur Erzeugung eines zweiten Teils des Gatedielektrikums wird wie im ersten Ausführungsbeispiel eine thermische Oxidation durchgeführt, wodurch Flanken der Halbleiterstruktur St, mit SiO₂ versehen werden.

Zur Erzeugung eines zweiten Teil der ersten Gateelektrode Ga1' wird in situ dotiertes Polysilizium in einer Dicke von ca. 30 nm abgeschieden und bis zur ersten Höhe zurückgeätzt. Analog wie im ersten Ausführungsbeispiel wird eine Hilfsschicht erzeugt, SiO₂ an oberen Hälften der Flanken entfernt und die erste Gateelektrode Ga1' an einer zweiten Flanke der Halbleiterstruktur St' verkleinert, indem mit Hilfe einer Maske, die eine erste, der zweiten Flanke gegenüberliegende Flanke der Halbleiterstruktur St' bedeckt, das Polysilizium bis zu einer dritten Höhe zurückgeätzt wird.

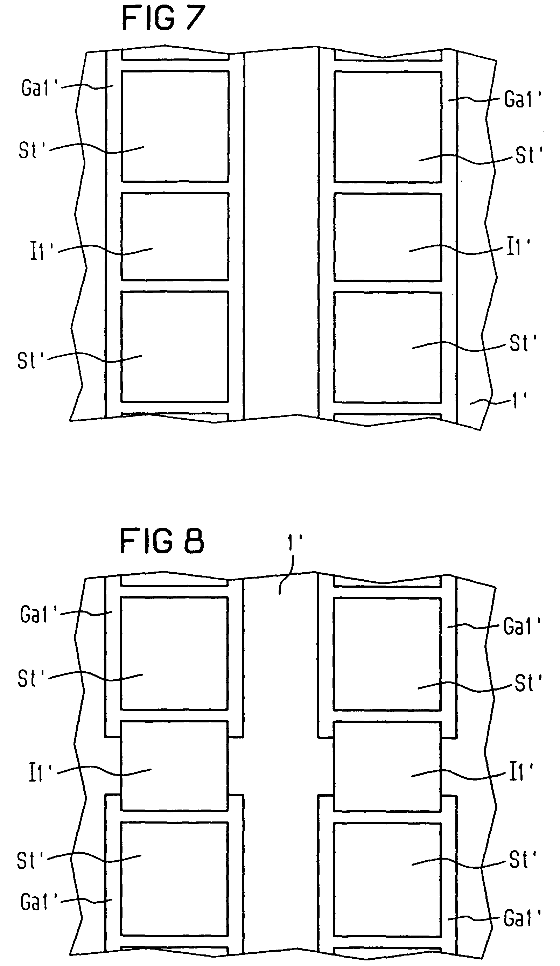

Um senkrecht zur x-Achse x' benachbarte erste Gateelektroden Ga1' voneinander zu isolieren, wird mit Hilfe einer streifenförmigen Maske (nicht dargestellt), deren Streifen parallel zur x-Achse x' verlaufen und die Halbleiterstrukturen St' bedecken, Polysilizium entfernt (s. Figur 8).

Anschließend werden wie im ersten Ausführungsbeispiel eine isolierende dotierte Schicht erzeugt, das Gatedielektrikum fertiggestellt, eine zweite isolierende Struktur, eine schreibende Wortleitung, eine auslesende Wortleitung, eine zweite Gateelektrode eines zweiten Transistors, eine dritte Gateelektrode eines dritten Transistors, ein erstes dotiertes Gebiet, ein zweites dotiertes Gebiet, eine dritte isolierende Struktur und eine Bitleitung erzeugt.

Es sind viele Variationen der Ausführungsbeispiele denkbar, die ebenfalls im Rahmen der Erfindung liegen. Insbesondere können die Abmessungen der beschriebenen Schichten, Strukturen, Bereiche und Höhen an die jeweiligen Erfordernisse angepaßt werden. Dasselbe gilt auch für die vorgeschlagenen Dotierstoffkonzentrationen. Strukturen aus SiO₂ können insbesondere durch thermische Oxidation oder durch ein Abscheidungsverfahren erzeugt werden. Polysilizium kann sowohl wahrend als auch nach der Abscheidung dotiert werden. Statt dotiertem Polysilizium lassen sich auch z.B. Metallsilizide und/oder Metalle verwenden. Kleinere oder leicht größere Strukturen als die minimale, in der verwendeten Technologie herstellbaren Strukturgröße lassen sich mit Über-oder Unterätzen von Masken erzeugen. Statt Wolfram für die Bitleitung lassen sich auch andere leitende Materialien, wie z.B. Aluminium verwenden.

## Patentansprüche

1. DRAM-Zellenanordnung,
- mit Speicherzellen, die jeweils mindestens einen ersten Transistor, einen zweiten Transistor und einen dritten Transistor umfassen,
- bei der der erste Transistor, der zweite Transistor und der dritte Transistor bezuglich einer y-Achse (y), die senkrecht zu einer Oberflache (O) eines Substrats (1) verlauft, vertikal ausgebildet sind,
- bei der eine erste Gateelektrode (Ga1) des ersten Transistors mit einem ersten Source/Drain-Gebiet des zweiten Transistors verbunden ist,
- bei der ein zweites Source/Drain-Gebiet (2S/D2) des zweiten Transistors mit einer schreibenden Bitleitung verbunden ist,
- bei der eine zweite Gateelektrode (Ga2) des zweiten Transistors mit einer schreibenden Wortleitung (WS) verbunden ist,
- bei der eine dritte Gateelektrode (Ga3) des dritten Transistors mit einer auslesenden Wortleitung (WA) verbunden ist,
- bei der ein zweites Source/Drain-Gebiet des ersten Transistors mit einem ersten Source/Drain-Gebiet des dritten Transistors verbunden ist,
- bei der ein zweites Source/Drain-Gebiet (3S/D2) des dritten Transistors mit einer auslesenden Bitleitung verbunden ist,
- bei der der erste Transistor und der zweite Transistor bezuglich der y-Achse (y) übereinander angeordnet sind,
- bei der der erste Transistor und der dritte Transistor bezuglich der y-Achse (y) übereinander angeordnet sind.

2. DRAM-Zellenanordnung nach Anspruch 1,
- bei der der zweite Transistor im wesentlichen an einer ersten Flanke (F1) einer Halbleiterstruktur (St) angeordnet ist,
- bei der der dritte Transistor im wesentlichen an einer zweiten Flanke (F2) der Halbleiterstruktur (St) angeordnet ist,
- bei der die erste Flanke (F1) und die zweite Flanke (F2) mit einem Gatedielektrikum (Gd) versehen sind,
- bei der die schreibende Wortleitung (WS) entlang der ersten Flanke (F1) verlauft,
- bei der die auslesende Wortleitung (WA) entlang der zweiten Flanke (F2) verlauft,
- bei der ein erster Teil der ersten Gateelektrode (Ga1) mindestens an die erste Flanke (F1) angrenzt,
- bei der ein zweiter Teil der ersten Gateelektrode (Ga1) mindestens an die zweite Flanke (F2) angrenzt,
- bei der der erste Teil der ersten Gateelektrode (Ga1) und der zweite Teil der ersten Gateelektrode (Ga1) zusammenhängend ausgebildet sind,
- bei der das Gatedielektrikum (Gd) im Bereich des ersten Teils der ersten Gateelektrode (Ga1) an der ersten Flanke (F1) eine Unterbrechung (U) aufweist.

3. DRAM-Zellenanordnung nach Anspruch 2,
- bei der an der ersten Flanke (F1) ein Element angeordnet ist, das die Ausbildung eines Kanalstroms zwischen dem ersten Source/Drain-Gebiet (1S/D1) des ersten Transistors und dem ersten Source/Drain-Gebiet des zweiten Transistors unterdrückt.

4. DRAM-Zellenanordnung nach einem der Ansprüche 2 bis 3,
- bei der ein oberes Ende des ersten Teils der ersten Gateelektrode (Ga1) bezüglich der y-Achse (y) in einer zweiten Höhe (H2) liegt, die höher als eine dritte Höhe (H3) ist, in der ein oberes Ende des zweiten Teils der ersten Gateelektrode (Ga1) liegt,
- bei der sich die Unterbrechung (U) des Gatedielektrikums (Gd) bezüglich der y-Achse (y) oberhalb der dritten Höhe (H3) befindet.

5. DRAM-Zellenanordnung nach einem der Ansprüche 1 bis 4,
- bei der das zweite Source/Drain-Gebiet des ersten Transistors und das erste Source/Drain-Gebiet des dritten Transistors ein erstes dotiertes Gebiet (D1) bilden.

6. DRAM-Zellenanordnung nach einem der Ansprüche 1 bis 5,
- bei der das erste Source/Drain-Gebiet des zweiten Transistors als zweites dotiertes Gebiet (D2) ausgebildet ist, das in einem Bereich der Unterbrechung (U) des Gatedielektrikums (Gd) an den ersten Teil der ersten Gateelektrode (Ga1) angrenzt.

7. DRAM-Zellenanordnung nach einem der Ansprüche 1 bis 6,
- bei der die schreibende Bitleitung mit der auslesenden Bitleitung zusammenfallt und eine Bitleitung (B) bilden.

8. Verfahren zur Herstellung einer DRAM-Zellenanordnung,
- bei dem Speicherzellen, die jeweils mindestens einen ersten Transistor, einen zweiten Transistor und einen dritten Transistor umfassen, erzeugt werden,
- bei der schreibende Wortleitungen (WS) und auslesende Wortleitungen (WA) und quer zu den schreibenden Wortleitungen (WS) und den auslesenden Wortleitungen (WA) Bitleitungen (B) erzeugt werden,
- bei dem Gateelektroden, erste Source/Drain-Gebiete und zweite Source/Drain-Gebiete erzeugt werden,
- bei dem eine erste Gateelektrode (Ga1) des ersten Transistors mit einem ersten Source/Drain-Gebiet des zweiten Transistors verbunden wird,
- bei dem ein zweites Source/Drain-Gebiet (2S/D2) des zweiten Transistors mit einer schreibenden Bitleitung verbunden wird,
- bei dem eine zweite Gateelektrode (Ga2) des zweiten Transistors mit einer der schreibenden Wortleitungen (WS) verbunden wird,
- bei dem eine dritte Gateelektrode (Ga3) des dritten Transistors mit einer der auslesenden Wortleitungen (WA) verbunden wird,
- bei dem ein zweites Source/Drain-Gebiet des ersten Transistors mit einem ersten Source/Drain-Gebiet des dritten Transistors verbunden wird,
- bei dem ein zweites Source/Drain-Gebiet (3S/D2) des dritten Transistors mit einer auslesenden Bitleitung verbunden wird,
- bei dem der erste Transistor, der zweite Transistor und der dritte Transistor bezüglich einer y-Achse (y), die senkrecht zu einer Oberfläche (O) eines Substrats (1) verläuft, vertikal gebildet werden,
- bei dem der erste Transistor und der zweite Transistor bezüglich der y-Achse (y) übereinander gebildet werden,
- bei dem der erste Transistor und der dritte Transistor bezüglich der y-Achse (y) übereinander gebildet werden.

9. Verfahren nach Anspruch 8,
- bei dem der erste Transistor, der zweite Transistor und der dritte Transistor an einer Halbleiterstruktur (St) gebildet werden,
- bei dem der zweite Transistor im wesentlichen an einer ersten Flanke (F1) der Halbleiterstruktur (St) gebildet wird,
- bei dem der dritte Transistor im wesentlichen an einer zweiten Flanke (F2) der Halbleiterstruktur (St) gebildet wird,
- bei dem die erste Flanke (F1) und die zweite Flanke (F2) mit einem Gatedielektrikum (Gd) versehen werden,
- bei dem die schreibende Wortleitung (WS) entlang der ersten Flanke (F1) verlaufend gebildet wird,
- bei dem die auslesende Wortleitung (WA) entlang der zweiten Flanke (F2) verlaufend ausgebildet wird,
- bei dem ein erster Teil der ersten Gateelektrode (Ga1) angrenzend an mindestens die erste Flanke (F1) gebildet wird,
- bei dem ein zweiter Teil der ersten Gateelektrode (Ga1) angrenzend an mindestens die zweite Flanke (F2) gebildet wird,
- bei dem der erste Teil der ersten Gateelektrode (Ga1) und der zweite Teil der ersten Gateelektrode (Ga1) zusammenhängend gebildet werden,
- bei dem das Gatedielektrikum (Gd) in einem Bereich des ersten Teils der ersten Gateelektrode (Ga1) an der ersten Flanke (F1) mit einer Unterbrechung (U) versehen wird.

10. Verfahren nach Anspruch 8 oder 9,
- bei dem an der ersten Flanke (F1) ein Element gebildet wird, das die Ausbildung eines Kanalstroms zwischen dem ersten Source/Drain-Gebiet (1S/D1) des ersten Transistors und im ersten Source/Drain-Gebiet des zweiten Transistors unterdrückt.

11. Verfahren nach Anspruch 10,
- bei dem nach Erzeugung der Halbleiterstruktur (St) eine Dotierstoffquelle erzeugt wird, die die erste Flanke (F1) mindestens in einem Bereich unterhalb der zu erzeugenden Unterbrechung (U) bedeckt,
- bei dem das Element, das die Ausbildung eines Kanalstroms zwischen dem ersten Source/Drain-Gebiet (1S/D1) des ersten Transistors und im ersten Source/Drain-Gebiet des zweiten Transistor unterdrückt, in Form eines Channel-Stop-Gebiets (C) gebildet wird,
- bei dem zur Erzeugung des Channel-Stop-Gebiets (C) Dotierstoff aus der Dotierstoffquelle in die Halbleiterstruktur (St) diffundiert wird.

12. Verfahren nach einem der Ansprüche 9 bis 11,
- bei dem die erste Gateelektrode (Ga1) so erzeugt wird, daß ein oberes Ende des ersten Teils der ersten Gateelektrode (Ga1) bezüglich der y-Achse (y) in einer zweiten Höhe (H2) liegt, die höher als eine dritte Höhe (H3) ist, in der ein oberes Ende des zweiten Teils der ersten Gateelektrode (Ga1) liegt,
- bei dem das Gatedielektrikum (Gd) so gebildet wird, daß sich die Unterbrechung (U) bezuglich der y-Achse (y) oberhalb der dritten Höhe (H3) befindet.

13. Verfahren nach Anspruch 12,
- bei dem nach Erzeugung der Halbleiterstruktur (St) eine thermische Oxidation durchgeführt wird, wodurch ein Teil des Gatedielektrikums (Gd) erzeugt wird,
- bei dem zur Erzeugung der ersten Gateelektrode (Ga1) ein erstes Material abgeschieden und bis zur ersten Höhe (H1) rückgeätzt wird,
- bei dem durch die thermische Oxidation erzeugtes SiO₂ von freiliegenden Teilen der ersten Flanke (F1) und der zweiten Flanke (F2) entfernt wird,
- bei dem zur Erzeugung des ersten Teils der ersten Gateelektrode (Ga1) weiteres erstes Material abgeschieden und bis zur zweiten Höhe (H2) rückgeätzt wird,
- bei dem zur Erzeugung des zweiten Teils der ersten Gateelektrode (Ga1) mit Hilfe einer Maske, die mindestens den ersten Teil der ersten Gateelektrode (Ga1) bedeckt, das erste Material teilweise bis zur dritten Höhe (H3), die unterhalb der ersten Höhe (H1) liegt, geätzt wird,
- bei dem durch eine thermische Oxidation mindesten an der ersten Flanke (F1), außer im Bereich zwischen der ersten Höhe (H1) und der zweiten Höhe (H2), das Gatedielektrikum (Gd) vervollständigt wird.

14. Verfahren nach einem der Ansprüche 8 bis 13,
- bei dem ein erstes dotiertes Gebiet (D1) gebildet wird, das das zweite Source/Drain-Gebiet des ersten Transistors und das erste Source/Drain-Gebiet des dritten Transistors umfaßt.

15. Verfahren nach Anspruch 14,
- bei dem das erste dotierte Gebiet (D1) erzeugt wird, indem angrenzend an die zweite Flanke (F2) mindestens teilweise oberhalb des zweiten Teils der ersten Gateelektrode (Ga1) eine Schicht (Sd) abgeschieden wird, aus der in einem Temperschritt Dotierstoff in die Halbleiterstruktur (St) ausdiffundiert wird.

16. Verfahren nach einem der Ansprüche 9 bis 15,
- bei dem das erste Source/Drain-Gebiet des zweiten Transistors als zweites dotiertes Gebiet (D2) gebildet wird, indem durch einen Temperschritt im Bereich der Unterbrechung (U) des Gatedielektrikums (Gd) Dotierstoff in die Halbleiterstruktur (St) diffundiert wird.

17. Verfahren nach einem der Ansprüche 8 bis 16,
- bei dem durch Abscheiden und Rückätzen und/oder chemisch mechanischem Polieren von Material an der ersten Flanke (F1) die schreibende Wortleitung (WS) und an der zweiten Flanke (F2) die auslesende Wortleitung (WA) entstehen,
- bei dem die zweite Gateelektrode (Ga2) als Teil der schreibenden Wortleitung (WS) und die dritte Gateelektrode (Ga3) als Teil der auslesenden Wortleitung (WA) erzeugt werden.

18. Verfahren nach einem der Ansprüche 8 bis 17,
- bei dem die schreibende Bitleitung und die auslesende Bitleitung so gebildet werden, daß sie zusammenfallen und eine Bitleitung (B) bilden.
